# EUROPÄISCHE PATENTSCHRIFT

(11) **EP 3 830 586 B1**
(45) Veröffentlichungstag und Bekanntmachung des Hinweises auf die Patenterteilung: **20.08.2025**
(21) Anmeldenummer: 19778802.9
(22) Anmeldetag: 06.09.2019
(51) Int. Cl.: G01R 15/24, G02B 6/00

(54) **MONOLITHISCHER GLASRING UND VERFAHREN FÜR OPTISCHE STROMMESSUNGEN**
MONOLITHIC GLASS RING AND METHOD FOR OPTICAL CURRENT MEASUREMENTS
ANNEAU DE VERRE MONOLITHIQUE ET PROCÉDÉ POUR MESURES DE COURANT OPTIQUES

(30) Priorität: 26.09.2018 DE 102018216482
(43) Veröffentlichungstag der Anmeldung: 09.06.2021
(73) Patentinhaber: HSP Hochspannungsgeräte GmbH, 53842 Troisdorf (DE)
(72) Erfinder: SCHUBERTH, Stefan, 96215 Lichtenfels (DE)
(74) Vertreter: Betten & Resch
(86) Internationale Anmeldenummer: PCT/EP2019/073808
(87) Internationale Veröffentlichungsnummer: WO 2020/064301

(56) Entgegenhaltungen:
- EP-A1- 0 088 419
- DE-A1- 4 342 409
- YOSHINO T ET AL: "SINGLE GLASS BLOCK FARADAY EFFECT CURRENT SENSOR WITH HOMOEGENEOUS ISOTROPIC CLOSED OPTICAL CIRCUIT", APPLIED OPTICS, OPTICAL SOCIETY OF AMERICA, WASHINGTON, DC; US, vol. 36, no. 22, 1 August 1997 (1997-08-01), pages 5566 - 5573, XP000720879, ISSN: 0003-6935, DOI: 10.1364/AO.36.005566
- NING Y N ET AL: "MINIATURE FARASAY CURRENT SENSOR BASED ON MULTIPLE CRITICAL ANGLE REFLECTIONS IN A BULK-OPTIC RING", OPTICS LETTERS, OPTICAL SOCIETY OF AMERICA, US, vol. 16, no. 24, 15 December 1991 (1991-12-15), pages 1996 - 1998, XP000244022, ISSN: 0146-9592
- NING Y N ET AL: "A Faraday current sensor using a novel multi-optical-loop sensing element", MEASUREMENT SCIENCE AND TECHNOLOGY, IOP, BRISTOL, GB, vol. 6, no. 9, 1 September 1995 (1995-09-01), pages 1339 - 1342, XP020066026, ISSN: 0957-0233, DOI: 10.1088/0957-0233/6/9/014

## Beschreibung

Die Erfindung betrifft einen Glasring für Strommessungen und ein Verfahren zur optischen Strommessung, mit einem Glaskörper, welcher um einen elektrischen Leiter anordenbar ist und eine Licht-Eintrittsfläche und eine Licht-Austrittsfläche aufweist. Der Glasring ist ausgebildet, Licht, welches durch die Licht-Eintrittsfläche in den Glaskörper eintritt, in dem Glaskörper durch Reflektion an Außenseiten des Glaskörpers um den Leiter vollständig umlaufen zu lassen, wobei das Licht an der Licht-Austrittsfläche aus dem Glaskörper austritt.

Ein elektrischer Strom wird z. B. resistiv über einen Spannungsabfall an einem Widerstand gemessen. Ein Wechselstrom erzeugt ein elektromagnetisches Feld um einen stromdurchflossenen Leiter, welches induktiv z. B. über einen Messtransformator und/oder optisch mit Hilfe des Faraday-Effektes gemessen werden kann. Hohe Ströme, insbesondere im Bereich von einigen hundert Ampere, sind vorteilhaft über Induktion und/oder den Faraday-Effekt zu messen, da diese Methoden den Widerstand im stromdurchflossenen Leiter bzw. Primärleiter nicht erhöhen. Zur Strommessung mit dem Faraday-Effekt wird polarisiertes Licht um einen stromdurchflossenen Leiter herum geleitet. Dazu werden polarisationserhaltenden Lichtwellenleiter oder z. B. ein Glasring verwendet. Dabei wird Glas mit einer Verdet-Konstante ungleich Null verwendet.

Das Magnetfeld des stromdurchflossenen Leiters führt im Glas zu einer zusätzlichen Drehung der Polarisationsebene des eingestrahlten Lichts, die mit verschiedenen Methoden gemessen werden kann und direkt proportional zum Strom im Leiter ist. Verwendete Glasringe zeigen im Vergleich zu Lichtwellenleitern wesentlich geringere Temperatur- und Vibrationseffekte, sind jedoch ohne Glasklebung bisher nicht herstellbar. Derartige Glasringe sind z. B. aus der US 4,564,754 bekannt. Ein verwendeter Glasring umfasst vier Ecken und weist im Wesentlichen eine rechteckige Form auf. An jeder der vier Ecken des rechteckigen Glasrings wird der Lichtstrahl über zwei zueinander gekippte Flächen um 90 Grad reflektiert, um die Polarisationsebene nicht zu verändern. Dadurch ist die Glasringgeometrie zum Teil festgelegt. Eine zweite Randbedingung sind die Möglichkeiten eines Schleif- und Polierprozesses bei der Herstellung eines derartigen Glasrings. Dabei können jeweils nur ganze Flächen ohne Absätze poliert werden.

Die Randbedingungen führen dazu, dass der derart herstellbare Glasring keinen 360 Grad Umlauf für Licht um den Leiter ermöglicht oder Licht weder ein- noch ausgekoppelt werden kann. Die Herstellung derartiger Glasringe, welche ein Ein- und Auskoppeln von Licht ermöglichen sowie einen 360 Grad Umlauf für Licht um den Leiter ermöglichen, erfordert ein Zusammensetzen des polarisationserhaltenden Glasrings aus mehreren Teilen. Die Teile werden zusammengesetzt und verklebt. Dadurch lassen sich die Einschränkungen des Polierprozess umgehen. Um keine mechanischen Spannungen durch die Klebestellen in einen Glaskörper des Glasrings zu induzieren, was zu Spannungsdoppelbrechung und Polarisationseffekten führt, benötigen Glasklebersysteme in diesem Fall sehr lange Abbindezeiten. Die verwendeten Kleber sind nur in bestimmten Anwendungstemperaturbereichen einsetzbar. Wird der Temperaturbereich Überschritten, so verändern sich die mechanischen Parameter. Der Kleber kann degradieren und Farbveränderungen zeigen, was in einem optischen Messsystem zu Messwertdriften und nicht akzeptablen Messabweichungen führt.

Die Einsatzgebiete eines verklebten Glasrings, zusammengesetzt aus mehreren monolithischen Glaskörpern, sind daher eingeschränkt. Der Einsatz zur Strommessung ist nur bedingt möglich, da die Degradation und/oder Verfärbung des Klebers und/oder mechanische Spannungen kein langzeitstabiles Messsystem erlauben. Messungen mit einem verklebten Glasring führen zu Messfehlern insbesondere nach einer Eichung, welche mit der Zeit zunehmen. Weiterhin führt der Kleber zu mechanischen Problemen, insbesondere bei Temperaturen außerhalb eines zulässigen Temperaturbereichs. Die Herstellung verklebter Glasringe ist aufwendig, zeit- und kostenintensiv. Weitere Glasringe sind aus der DE 43 42 409 A1 und der EP 0 088 419 A1 bekannt.

Aufgabe der vorliegenden Erfindung ist es, einen Glasring für Strommessungen und ein Verfahren zur optischen Strommessung anzugeben, welche die zuvor beschriebenen Probleme lösen. Insbesondere ist es Aufgabe, einen langzeitstabilen, einfach und ohne hohe Kosten herstellbaren Glasring anzugeben, welcher bei optischen Strommessungen keine bzw. geringe Messfehler ergibt und mechanisch stabil ist, insbesondere in einem breiten Temperaturbereich und über lange Zeiträume.

Die angegebene Aufgabe wird erfindungsgemäß durch einen Glasring für Strommessungen mit den Merkmalen gemäß Patentanspruch 1 und/oder durch ein Verfahren zur optischen Strommessung, insbesondere mit einem zuvor beschriebenen Glasring, gemäß Patentanspruch 4 gelöst. Vorteilhafte Ausgestaltungen des erfindungsgemäßen Glasrings für Strommessungen und/oder des Verfahrens zur optischen Strommessung, insbesondere mit einem zuvor beschriebenen Glasring, sind in den Unteransprüchen angegeben. Dabei sind Gegenstände der Hauptansprüche untereinander und mit Merkmalen von Unteransprüchen sowie Merkmale der Unteransprüche untereinander kombinierbar.

Ein erfindungsgemäßer Glasring für Strommessungen umfasst einen Glaskörper, welcher um einen elektrischen Leiter anordenbar ist und eine Licht-Eintrittsfläche und eine Licht-Austrittsfläche aufweist. Der Glasring ist ausgebildet, Licht, welches durch die Licht-Eintrittsfläche in den Glaskörper eintritt, in dem Glaskörper durch Reflektion an Außenseiten des Glaskörpers um den Leiter vollständig umlaufen zu lassen, wobei das Licht an der Licht-Austrittsfläche aus dem Glaskörper austritt. Der Glasring ist erfindungsgemäß aus einem monolithischen Glaskörper ausgebildet.

Durch die Ausbildung des Glasrings aus einem monolithischen Glaskörper, ohne Klebungen, ist eine optische Änderung des Lichts durch einen Kleber ausgeschlossen. Alterungseffekte eines Klebers auf Licht im Glasring sind ausgeschlossen und Temperatureffekte auf die Stabilität des Glasrings, z. B. durch kritische Änderung der mechanischen Stabilität bei Temperaturen außerhalb eines gegebenen Temperaturbereichs, sind nicht gegeben. Das optische Verhalten des erfindungsgemäß monolithischen Glasrings ist langzeitstabil und ein derartiger Glasring, welcher polarisationserhaltend für Licht ist und ein Ein- und Auskoppeln von Licht sowie einen 360 Grad Umlauf für Licht um einen elektrischen Leiter ermöglicht, ist einfach, mechanisch stabil, und ohne großen Aufwand insbesondere durch Polieren von Seitenflächen herstellbar.

Der Glasring umfasst zwei sich gegenüberliegende Seiten, insbesondere eine fünfte und eine sechste Seite. Insbesondere sind zwei parallel zueinander angeordnete ebene sich gegenüberliegende Seiten umfasst, welche jeweils genau vier Ecken aufweisen. Der Glasring weist eine durchgehende, kreiszylinderförmige Öffnung auf, welche insbesondere durch die zwei Seiten hindurchgeführt ist. Durch die Öffnung kann ein elektrischer Leiter geführt sein, insbesondere angeordnet mit einer Längsachse senkrecht zu den zwei parallel zueinander angeordneten, ebenen, sich gegenüberliegende Seiten. Dies ermöglicht eine Strommessung des Stroms in dem elektrischen Leiter über das elektromagnetische Feld des Leiters, welches in den Glasring ragt. Eine Änderung der Polarisation von Licht in dem Glasring erfolgt abhängig des elektromagnetischen Felds und somit abhängig der Stromstärke im Leiter, insbesondere proportional.

Der Glasring kann ausgebildet sein, dass bei einem Lichtumlauf um den Leiter die Polarisation des Lichts im Wesentlichen vollständig erhalten ist. Dadurch wird die Messung des Stroms im Leiter möglich, da eine Polarisationsänderung des Lichts nicht durch den Glasring selbst, sondern nur durch elektromagnetische Felder des Leiters erfolgt. Ein Umlauf von Licht um den Leiter ermöglicht ausreichend Wechselwirkung des Lichts mit dem elektromagnetischen Feld des stromdurchflossenen Leiters, so dass eine messbare Polarisationsänderung des Lichts durch das elektromagnetische Feld des stromdurchflossenen Leiters erfolgen kann. Dadurch wird die Messung der Stromstärke im Leiter mit Hilfe des Glasrings möglich.

Die Licht-Eintrittsfläche ist eine dritte Seite des Glasrings, welche zwei benachbarte, um einen Winkel gegeneinander gekippte Teilflächen umfasst, wobei eine Teilfläche insbesondere eine Dreiecksform aufweist. Die schräg angebrachte bzw. um einen Winkel gekippte Teilfläche insbesondere in Dreiecksform ermöglicht, dass genügend Fläche für den Licht-Eintritt und/oder -Austritt zur Verfügung steht, und dadurch ein Ein- und Auskoppeln von Licht in bzw. aus dem Glasring möglich ist.

Benachbart zur dritten Seite des Glasrings ist eine zweite Seite angeordnet, welche benachbart zur sechsten Seite eine erste, insbesondere trapezförmige planare Teilfläche umfasst. Die zweite Seite umfasst benachbart zur fünften Seite eine trapezförmige Teilfläche, welche aus zwei gegeneinander verkippten insbesondere dreiecksförmigen Flächen, einer zweiten und dritten Teilfläche der zweiten Seite, zusammengesetzt ist. Das Verkippen der insbesondere dreiecksförmigen Flächen, der zweiten und dritten Teilfläche der zweiten Seite, repositioniert einen Lichtstrahl derart, dass dieser an der Licht-Austrittsfläche den Glasring verlässt. Dadurch ist ein Licht-Austritt aus dem Glasring möglich und es ist eine Messung außerhalb des Glasrings möglich der Polarisationsänderung des Lichts im Glasring durch das elektromagnetische Feld des stromdurchflossenen Leiters, mit den zuvor beschriebenen Vorteilen.

Die dritte Teilfläche der zweiten Seite ist um einen Winkel von wenigen Grad, nämlich 2 Grad, gegen die zweite Teilfläche der zweiten Seite verkippt sein. Eine Verkippung um nur wenige Grad, nämlich 2 Grad, ergibt die zuvor beschriebenen Vorteile.

Insbesondere benachbart zur zweiten Seite ist eine vierte Seite umfasst, welche aus zwei benachbart zueinander angeordneten, gegeneinander verkippten Teilflächen aufgebaut ist, wobei jede Teilfläche insbesondere trapezförmig ausgebildet ist. Durch die Teilflächen, insbesondere eine Teilfläche, wird ein Lichtstrahl auf einem Umlauf im Glasring in Richtung fünfte Seite bzw. auf eine erste Teilfläche der ersten Seite reflektiert. Dadurch wird ein geschlossener Umlauf ohne Polarisationsänderung durch den Glasring bzw. Glaskörper selbst ermöglicht, mit den zuvor beschriebenen Vorteilen.

Benachbart zur dritten Seite ist eine erste Seite umfasst, welche aus zwei benachbart zueinander angeordneten, gegeneinander verkippten Teilflächen aufgebaut ist, wobei jede Teilfläche insbesondere trapezförmig ausgebildet ist. Durch die Teilflächen, insbesondere eine Teilfläche, wird ein Lichtstrahl auf einem Umlauf im Glasring in Richtung zweite Seite bzw. auf eine erste Teilfläche der zweiten Seite reflektiert. Dadurch wird ein geschlossener Umlauf ohne Polarisationsänderung durch den Glasring bzw. Glaskörper selbst ermöglicht, mit den zuvor beschriebenen Vorteilen.

Der Glaskörper kann ein Glas mit einer Verdet-Konstante größer oder kleiner Null umfassen und/oder aus einem Glas mit einer Verdet-Konstante größer oder kleiner Null bestehen. Dabei gibt die Verdet-Konstante eine Materialeigenschaft wieder, welche die Stärke des Faraday-Effekts in einem bestimmten Material bzw. Stoff angibt. Der Wert hängt von der Wellenlänge des Lichts ab und ist positiv für einen Stoff bzw. ein Material, d. h**.** insbesondere für Glas, welches sich bei Licht, das sich parallel zu den Magnetfeldlinien ausbreitet, linksdrehend auswirkt. Durch eine Verdet-Konstante ungleich Null des Glases, aus welchem der Glaskörper bzw. der Glasring besteht, wirkt ein elektromagnetisches Feld auf das Licht und ändert abhängig der Größe des Feldes bzw. abhängig vom Strom im stromdurchflossenen Leiter die Polarisation des Lichts. Da das Glas ohne elektromagnetisches Feld die Polarisation des Lichts im Glasring nicht bzw. im Wesentlichen nicht ändert, kann über die Änderung der Polarisation im Glasring ein Strom im stromdurchflossenen Leiter gemessen bzw. bestimmt werden.

Ein erfindungsgemäßes Verfahren zur optischen Strommessung, insbesondere mit einem zuvor beschriebenen Glasring umfasst, dass ein Stromfluss in einem elektrischen Leiter ein elektromagnetisches Feld um den Leiter herum erzeugt, über welches die Polarisation eines Lichtstrahls in einem Glasring, welcher um den Leiter herum angeordnet wird, insbesondere mit einer Ebene senkrecht zur Leiterlängsachse, bei einem Umlauf des Lichtstrahls um den Leiter herum geändert wird.

Der Lichtstrahl bei einem Umlauf um den Leiter kann einen monolithischen Glaskörper durchlaufen, wobei Richtungsänderungen des Lichtstrahls über Reflektion an Außenseiten des Glaskörpers erfolgen, insbesondere an einer gegen eine zweite Teilfläche der zweiten Seite verkippten, insbesondere um einen Winkel von 2 Grad verkippten, dritten Teilfläche der zweiten Seite, und/oder an einer um wenige Grad verkippten Teilfläche, insbesondere in Dreiecksform, der dritten Seite des Glasrings. Die um wenige Grad verkippte Teilfläche, insbesondere in Dreiecksform, der dritten Seite des Glasrings ermöglicht mit der anderen Teilfläche der dritten Seite, dass ausreichend Fläche für den Licht-Eintritt, und in Verbindung mit der sechsten Seite ausreichend Fläche für den Licht-Austritt aus dem Glasring besteht, um Licht in bzw. aus dem Glasring ein- bzw. auszukoppeln. Die dritte Teilfläche der zweiten Seite verkippt gegenüber der zweiten Teilfläche der zweiten Seiten, insbesondere um einen Winkel von 2 Grad verkippt, ermöglicht insbesondere durch Repositionieren des Lichtstrahls im Glasring den Licht-Austritt, an einer Licht-austrittsfläche, welche insbesondere Teile der sechsten Seite umfasst, benachbart zu dem Licht-Eintritt an der dritten Seite.

Durch die zuvor beschriebenen gekippten Flächen, welche durch Schneiden, Schleifen und/oder Polieren des Glaskörpers bzw. Glasrings einfach und günstig erzeugt werden können, ist eine hochtemperaturfähige optische Messeinrichtung für große Ströme herstellbar, welche langzeitstabil ist, ohne Alterungserscheinungen wie z. B. Änderung der Transmission und/oder Einfärbung durch Komponenten im Strahlengang des Lichts.

Das Licht kann durch die Licht-Eintrittsfläche in den Glaskörper eintreten und an der Licht-Austrittsfläche aus dem Glaskörper austreten. Das Licht kann insbesondere über die dritte Seite des Glasrings eintreten in den Glaskörper, insbesondere über zwei benachbarte, um einen Winkel gegeneinander gekippte Teilflächen, und/oder auf der sechsten Seite des Glasrings aus dem Glaskörper austreten, insbesondere mit einem Winkel von im Wesentlichen 90 Grad zum eintretenden Licht.

Die Vorteile des erfindungsgemäßen Verfahrens zur optischen Strommessung, insbesondere mit einem zuvor beschriebenen Glasring, gemäß Anspruch 10 sind analog den zuvor beschriebenen Vorteilen des erfindungsgemäßen Glasrings für Strommessungen gemäß Anspruch 1 und umgekehrt.

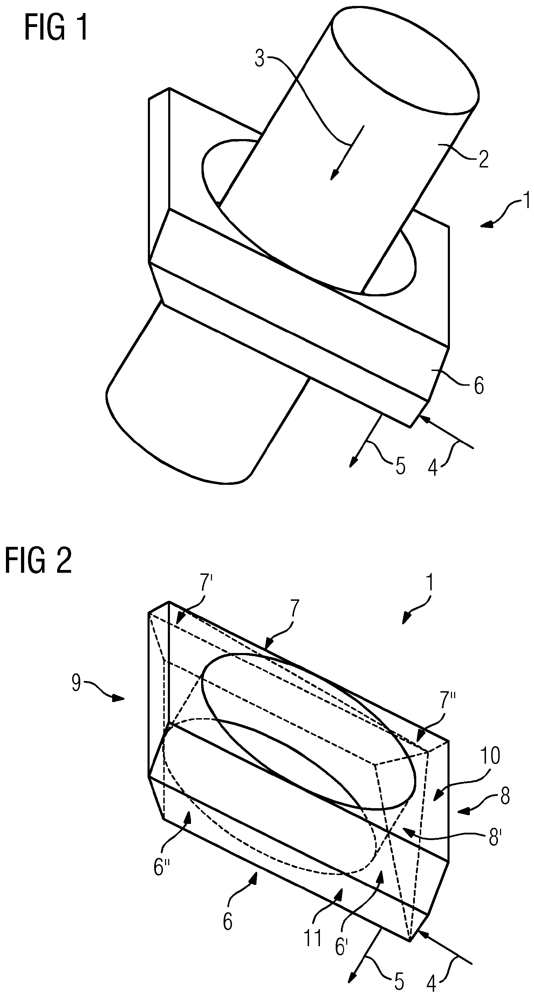

Im Folgenden wird ein Ausführungsbeispiel der Erfindung schematisch in den Figuren 1 und 2 dargestellt und nachfolgend näher beschrieben.

Dabei zeigen die
- Figur 1: schematisch in Schrägansicht eine Anordnung zur optischen Messung eines Stroms 3 in einem elektrischen Leiter 2 mit Hilfe eines erfindungsgemäßen Glasrings 1, und
- Figur 2: schematisch die Form bzw. Geometrie des Glasrings 1 der Figur 1.

In Figur 1 ist schematisch in Schrägansicht eine Anordnung zur optischen Messung eines Stroms 3, insbesondere im Bereich von bis zu einigen hundert Ampere, in einem elektrischen Leiter 2 mit Hilfe eines erfindungsgemäßen Glasrings 1 dargestellt. Der elektrische Leiter 2, z. B. ein Kupferleiter und/oder Kabel, ist beispielhaft zylinderförmig ausgebildet. Ein Strom 3 fließt in Richtung des Pfeils in Figur 1. Um den Leiter 2 ist ein Glasring 1 angeordnet, welcher den Leiter 2 vollständig umläuft. Der Glasring 1 ist mit einer Ebene, insbesondere einer parallelen Ober- und Unterseite entsprechend Figur 1, senkrecht zur Längsachse des zylinderförmigen Leiters 2 angeordnet. Der Glasring 1, mit seiner im Wesentlichen rechteckigen Grund- und Deckfläche bzw. insbesondere parallelen Ober- und Unterseite, weist mittig eine durchgehende, kreiszylinderförmige Öffnung auf, durch welche der Leiter 2 geführt ist.

Der Glasring 2 weist sechs Seiten auf, insbesondere eine parallele Ober- und Unterseite sowie vier seitliche Seiten entsprechend der Figur 1, wobei die Seiten den Glaskörper, d. h. das Glasmaterial des Glasrings 2, nach außen hin, d. h. insbesondere zur Umgebungsluft bzw. dem Umgebungsgas, abgrenzen. Das Glas bzw. Glasmaterial des Glasrings 1 ist z. B. ein Glas für optische Anwendungen, mit geringen Verunreinigungen und einer Verdet-Konstante insbesondere größer Null. Das Glas ist z. B. hochtemperaturbeständig.

Licht bzw. ein Lichtstrahl, insbesondere Licht einer bestimmten optischen Wellenlänge abgestimmt auf das Glasmaterial und dessen Brechungsindex sowie Absorptionsverhalten, welcher z. B. über einen Laser oder über eine Lichtquelle mit optischen Komponenten wie z. B. Linsen bereitgestellt wird, tritt z. B. über eine seitliche Seite in den Glasring 1 ein. Das Licht wird z. B. senkrecht zur Längsachse des Leiters 2 bzw. parallel zur parallelen Ober- und Unterseite des Glasrings 1 in den Glasring 1 eingestrahlt. Dabei ist der Mittelpunkt bzw. die Mittelachse des Lichtstrahls auf einen Bereich der Licht-Eintrittsseite gerichtet, welche benachbart zu einer Ecke des Glasrings 1 liegt, z. B. in Figur 1 die vordere untere rechte Ecke. Nach Reflektionen an Seiten bzw. Seitenflächen des Glasrings 1, wobei der Lichtstrahl im Glasring 1 den Leiter 2 einmal vollständig umläuft, tritt der Lichtstrahl bzw. das Licht auf der Licht-Austrittseite aus, in Figur 1 die Unterseite des Glasrings 1.

Der Bereich, in welchem das Licht austritt aus dem Glasring 1, ist im Ausführungsbeispiel der Figur 1 auf der Unterseite benachbart zur Ecke des Glasrings 1, benachbart zu der das Licht auf der Licht-Eintrittsseite eintritt. Die Licht-Eintrittsseite und die Licht-Austrittsseite liegen benachbart, mit einem Winkel zueinander im Wesentlichen von 90 Grad, wobei die Licht-Austrittsseite eine Unterseite des Glasrings gemäß Figur 1 ist und die Licht-Eintrittsseite eine seitliche Seite ist. Beim Umlauf des Lichts um den stromdurchflossenen Leiter 2 ändert das Licht seine Polarisation im Wesentlichen nur abhängig vom elektromagnetischen Feld des Stroms 3 im Leiter 2. Nach Eichung ergibt eine Messung der Polarisationsänderung des Lichts die Stromstärke im Leiter 2 z. B. in Ampere.

In Figur 2 ist die Geometrie des Glasrings 1 der Figur 1 mit seinen äußeren Begrenzungsseiten im Detail dargestellt. Dabei sind aus dem Blickwinkel der Figur 2 sichtbare Kanten mit durchgezogenen Linien gekennzeichnet, wobei verdeckte Kanten aus dem Blickwinkel der Figur 2 heraus mit gestrichelten Linien gekennzeichnet sind. Die obere Seite bzw. die obere Begrenzungsfläche des Glasrings 1 gemäß Figur 2 ist als fünfte Seite 10 bezeichnet. Die untere Seite bzw. die untere Begrenzungsfläche des Glasrings 1 gemäß Figur 2 ist als sechste Seite 11 bezeichnet. Die fünfte und sechste Seite 10, 11 sind parallel zueinander angeordnet und planar. Mittig werden beide Seiten 10 und 11 durch die durchgehende, kreiszylinderförmige Öffnung durchstoßen, d. h. weisen kreisförmige Durchbrüche auf, durch welche der Leiter 2 geführt ist, der der Einfachheit halber in Figur 2 nicht dargestellt ist.

Seitlich des Glasrings 1 schließen vier Seiten, die erste Seite 6, die zweite Seite 7, die dritte Seite 8, und die vierte Seite 9 den Glasring 1 ab, wobei jeweils zwei Seiten 6 und 7 sowie 8 und 9 einander gegenüberliegen. Die dritte Seite 8 ist die Licht-Eintrittsseite. Die dritte Seite 8 weist zwei Teilflächen auf, wobei die erste Teilfläche 8' der dritten Seite 8 die Form eines Dreiecks aufweist. Eine Kante des Dreiecks ist eine gemeinsame Kante mit der sechsten Seite 11 und eine weitere Kante ist eine gemeinsame Kante mit der zweiten Seite 7. Durch die Teilung der dritten Seite 8 in zwei Teilflächen, z. B. durch Schliff aus einer Fläche erzeugt, kann Licht in den Glasring 1 auf der dritten Seite 8 mit ausreichend Intensität eingekoppelt werden und auf der sechsten Seite 11 ausgekoppelt werden. Die zwei Teilflächen der dritten Seite 8 sind über eine gemeinsame, insbesondere gerade Kante miteinander verbunden, und schließen einen stumpfen Winkel miteinander ein.

Der dritten Seite 8 liegt die vierte Seite 9 gegenüber, welche aus zwei insbesondere trapezförmigen Teilflächen aufgebaut ist. Die zwei Teilflächen der vierten Seite sind über eine gemeinsame, insbesondere gerade Kante miteinander verbunden, und schließen einen stumpfen Winkel miteinander ein. Eine Teilfläche, die in Figur 2 obere Teilfläche bildet mit der zweiten Teilfläche, der in Figur 2 unteren Teilfläche ein walmdachförmiges Gebilde. Die obere Teilfläche ist z. B. im rechten Winkel zur fünften Seite 10 angeordnet, und die untere Teilfläche ist z. B. durch schrägen Schliff aus der Fläche erzeugt.

Die erste Seite 6 ist analog der vierten Seite 9 aufgebaut, nur mit umgekehrt angeordneten Teilflächen. Die zwei Teilflächen der ersten Seite sind über eine gemeinsame, insbesondere gerade Kante miteinander verbunden, und schließen einen stumpfen Winkel miteinander ein. Eine Teilfläche 6', die in Figur 2 obere Teilfläche bildet mit der zweiten Teilfläche 6", der in Figur 2 unteren Teilfläche ein walmdachförmiges Gebilde. Die untere Teilfläche 6'' ist z. B. im rechten Winkel zur sechsten Seite 11 angeordnet, und die obere Teilfläche 6' ist z. B. durch schrägen Schliff aus der Fläche erzeugt.

Die zweite Seite 7 ist analog der ersten Seite 6 aufgebaut, nur mit einer in Figur 2 oberen Teilfläche, welche nochmals in zwei Teilflächen 7' und 7" unterteilt ist. Die untere Teilfläche in Figur 2 ist z. B. im rechten Winkel zur sechsten Seite 11 angeordnet, und die oberen Teilflächen 7' und 7" sind durch schräge Schliffe aus der Fläche erzeugt. Die zwei oberen Teilflächen 7' und 7'' sind jeweils dreieckig ausgebildet, mit einer gemeinsamen Kante. Durch die Teilfläche 7'' erfolgt eine Repositionierung des Lichtstrahls beim Umlauf durch den Glasring 1, wodurch nach Reflektion an der Teilfläche 6' der Lichtstrahl aus dem Glasring 1 insbesondere senkrecht zur sechsten Seite 11 austreten kann.

Der Lichtstrahl tritt somit auf der dritten Seite 8, benachbart zur vorderen unteren Ecke in Figur 2, über beide Teilflächen der dritten Seite 8 in den Glasring 1 ein, wird an der in Figur 2 unteren Teilfläche der vierten Seite 9 reflektiert zur ersten Teilfläche 6' der ersten Seite 6, von dort wird der Lichtstrahl reflektiert zur ersten Teilfläche 7' der zweiten Seite 7 und weiter reflektiert zur in Figur 2 unteren Teilfläche der vierten Seite 9. Von der in Figur 2 unteren Teilfläche der vierten Seite 9 wird der Lichtstrahl zur ersten Teilfläche 8' der dritten Seite 8 reflektiert, und von dort weiter zur zweiten Teilfläche 7'' der zweiten Seite 7, wobei Reflektion zur und an der ersten Teilfläche 6' der ersten Seite 6 zur sechsten Seite 11 zu einem Austritt des Lichtstrahls aus dem Glasring 1 über die sechste Seite 11 führt. Dabei hat der Lichtstrahl den Leiter 2 einmal vollständig umlaufen und durch Reflektion an den Glasseiten seine Polarisation im Wesentlichen erhalten. Änderungen der Polarisation sind insbesondere ausschließlich durch das elektromagnetische Feld des Leiters 2 im Glasring 1 bei Stromfluss 3 im Leiter 2 erfolgt. Über Messungen des Grads der Polarisationsänderung kann der Wert des Stromflusses 3 derart bestimmt werden.

Die zuvor beschriebenen Ausführungsbeispiele können untereinander kombiniert werden und/oder können mit dem Stand der Technik kombiniert werden. So können z. B. Gläser für den Glasring 1 mit positiver oder mit negativer Verdet-Konstante verwendet werden. Der Glasring 1 kann aus einem quaderförmigen Körper, welcher durch Glasschnitt erzeugt ist, über Schliffe hergestellt werden. Alternativ oder zusätzlich können insbesondere abgeschrägte und/oder verkippte Flächen direkt durch Glasschnitt oder durch Polieren erzeugt werden. Die durchgehende Öffnung im Glasring 1 kann kreiszylinderförmig sein, oder z. B. abhängig von der Form des Leiters 2 bei insbesondere schienenförmigen Leitern 2 z. B. quadratisch, T-förmig oder doppel-T-förmig sein. Das Glas des Glasrings 1 bzw. der Glaskörper kann z. B. aus einem Corning-Glas sein, oder andere optische Gläser umfassen. Vorrichtungen zur Lichterzeugung, insbesondere für Licht einer Wellenlänge, welche der Einfachheit halber in den Figuren nicht dargestellt sind, können Laser und/oder Lampen mit Linsen und/oder Polarisationsfiltern umfassen. Vorrichtungen zur Analyse des Lichts, insbesondere für Licht einer Wellenlänge mit geänderter Polarisation, welche der Einfachheit halber in den Figuren ebenfalls nicht dargestellt sind, können Polarisationsfilter, Linsen und/oder Interferometer umfassen.

Der Glasring 1 kann aus einem Quader erzeugt werden, welcher insbesondere durch Glasschnitt hergestellt ist. Die abgeschrägten Teilflächen, insbesondere mit 135 Grad Winkel zur jeweils zugehörigen Quaderfläche bzw. um 45 Grad angeschliffen bzw. angeschrägt, z. B. die Teilflächen 6', 7' und die untere Teilfläche gemäß Figur 2 der vierten Seite 9, sind z. B. durch Glasschnitt und/oder -schliff herstellbar. Die um insbesondere 2 Grad zur Teilfläche 7' abgeschrägte Teilfläche 7" ist z. B. durch Schliff herstellbar und/oder durch Polieren. Die Teilfläche 8' ist ebenfalls durch Schnitt und/oder Schliff herstellbar, wobei alle Flächen endpoliert sein können. Weitere Bearbeitungsmethoden des Glasrings 1 können Bohren, Fräsen und/oder z. B. Laserbearbeitung umfassen.

### Bezugszeichenliste

- 1: Glasring
- 2: elektrischer Leiter
- 3: Richtung Stromfluss
- 4: Licht-Eintrittsfläche
- 5: Licht-Austrittsfläche
- 6: erste Seite, vordere Begrenzungsfläche
- 6': erste Teilfläche der ersten Seite, obere vordere Begrenzungsfläche
- 6": zweite Teilfläche der ersten Seite, untere vordere Begrenzungsfläche
- 7: zweite Seite, hintere Begrenzungsfläche
- 7': zweite Teilfläche der zweiten Seite, erste obere hintere Begrenzungsfläche
- 7": dritte Teilfläche der zweiten Seite, zweite obere hintere Begrenzungsfläche
- 8: dritte Seite, rechte seitliche Begrenzungsfläche
- 8': erste Teilfläche der dritten Seite, rechte untere seitliche Begrenzungsfläche
- 9: vierte Seite, linke seitliche Begrenzungsfläche
- 10: fünfte Seite, obere Begrenzungsfläche
- 11: sechste Seite, untere Begrenzungsfläche

## Patentansprüche

1. Glasring (1) für Strommessungen, mit einem Glaskörper, welcher um einen elektrischen Leiter (2) anordenbar ist und eine Licht-Eintrittsfläche (4) und eine Licht-Austrittsfläche (5) aufweist, wobei der Glasring (1) ausgebildet ist, Licht, welches durch die Licht-Eintrittsfläche (4) in den Glaskörper eintritt, in dem Glaskörper durch Reflektion an Außenseiten des Glaskörpers um den Leiter (2) vollständig umlaufen zu lassen, wobei das Licht an der Licht-Austrittsfläche (5) aus dem Glaskörper austritt, und wobei der Glasring (1) aus einem monolithischen Glaskörper ausgebildet ist,
wobei die Licht-Eintrittsfläche (4) eine dritte Seite (8) des Glasrings (1) ist, welche zwei benachbarte, um einen Winkel gegeneinander gekippte Teilflächen umfasst, wobei eine Teilfläche (8')eine Dreiecksform aufweist,
wobei, der Glasring (1) eine fünfte (10) und eine sechste (11) Seite umfasst, die sich gegenüberliegend und parallel zueinander angeordnet sind und jeweils genau vier Ecken aufweisen, und der Glasring (1) eine durchgehende, kreiszylinderförmige Öffnung aufweist, welche durch die fünfte (10) und die sechste (11) Seite hindurchgeführt ist,
wobei, benachbart zur dritten Seite (8) des Glasrings (1), eine zweite Seite (7) angeordnet ist, welche benachbart zur sechsten Seite (11) eine erste, trapezförmige planare Teilfläche umfasst, und welche benachbart zur fünften Seite (10) eine trapezförmige Teilfläche umfasst, welche aus zwei gegeneinander verkippten dreiecksförmigen Flächen (7', 7"), einer zweiten (7') und dritten (7'') Teilfläche der zweiten Seite (7), zusammengesetzt ist,
wobei die dritte (7'') Teilfläche der zweiten Seite (7) um einen Winkel von 2 Grad gegen die zweite (7') Teilfläche der zweiten Seite (7) verkippt ist,
wobei, benachbart zur zweiten Seite (7), eine vierte Seite (9) umfasst ist, welche aus zwei benachbart zueinander angeordneten, gegeneinander verkippten Teilflächen aufgebaut ist, wobei jede Teilfläche trapezförmig ausgebildet ist,
wobei, benachbart zur dritten Seite (8) eine erste Seite (6) umfasst ist, welche aus zwei benachbart zueinander angeordneten, gegeneinander verkippten Teilflächen (6', 6") aufgebaut ist, wobei jede Teilfläche trapezförmig ausgebildet ist, wobei die erste Teilfläche (8') der dritten Seite (8) angeordnet ist, einen von der vierten Seite (9) kommenden Lichtstrahl weiter zur zweiten Teilfläche (7'') der zweiten Seite (7) zu reflektieren, wobei Reflektion zur und an der ersten Teilfläche (6') der ersten Seite (6) zur sechsten Seite (11) zu einem Austritt des Lichtstrahls aus dem Glasring (1) über die sechste Seite (11) führt.

2. Glasring (1) nach Anspruch 1, **dadurch gekennzeichnet, dass** der Glasring (1) ausgebildet ist, dass bei einem Lichtumlauf um den Leiter (2) ohne Stromfluss die Polarisation des Lichts im Wesentlichen vollständig erhalten ist.

3. Glasring (1) nach einem der vorhergehenden Ansprüche, **dadurch gekennzeichnet, dass**
der Glaskörper ein Glas mit einer Verdet-Konstante größer oder kleiner Null umfasst und/oder aus einem Glas mit einer Verdet-Konstante größer oder kleiner Null besteht.

4. Verfahren zur optischen Strommessung mit einem Glasring (1) nach einem der vorhergehenden Ansprüche,
**dadurch gekennzeichnet, dass**
ein Stromfluss (3) in einem elektrischen Leiter (2) ein elektromagnetisches Feld um den Leiter (2) herum erzeugt, über welches die Polarisation eines Lichtstrahls in dem Glasring (1), welcher um den Leiter (2) herum angeordnet wird, insbesondere mit einer Ebene senkrecht zur Leiterlängsachse, bei einem Umlauf des Lichtstrahls um den Leiter (2) herum geändert wird.

5. Verfahren nach Anspruch 4,
**dadurch gekennzeichnet, dass**
der Lichtstrahl bei einem Umlauf um den Leiter (2) einen monolithischen Glaskörper durchläuft, wobei Richtungsänderungen des Lichtstrahls über Reflektion an Außenseiten des Glaskörpers erfolgen, insbesondere an einer gegen eine zweite (7') Teilfläche der zweiten Seite (7) verkippten, insbesondere um einen Winkel von 2 Grad verkippten, dritten Teilfläche (7") der zweiten Seite (7).

6. Verfahren nach einem der Ansprüche 4 oder 5,
**dadurch gekennzeichnet, dass**
das Licht durch die Licht-Eintrittsfläche (4) in den Glaskörper eintritt und an der Licht-Austrittsfläche (5) aus dem Glaskörper austritt, und/oder dass das Licht insbesondere über die dritte Seite (8) des Glasrings (1) eintritt in den Glaskörper, insbesondere über zwei benachbarte, um einen Winkel gegeneinander gekippte Teilflächen, und/oder auf der sechsten Seite (11) des Glasrings (1) aus dem Glaskörper austritt, insbesondere mit einem Winkel von im Wesentlichen 90 Grad zum eintretenden Licht.

## Claims

1. A glass ring (1) for current measurements, having a glass body that is arrangeable around an electrical conductor (2) and has a light entry surface (4) and a light exit surface (5), wherein the glass ring (1) is configured to allow light entering the glass body through the light entry surface (4) to completely circulate around the conductor (2) in the glass body due to reflection at external sides of the glass body, wherein the light exits the glass body at the light exit surface (5), and wherein
the glass ring (1) is formed from a monolithic glass body, wherein the light entry surface (4) is a third side (8) of the glass ring (1), which comprises two adjacent partial surfaces that are tilted through an angle with respect to one another, wherein a partial surface (8') has a triangular shape,
wherein, the glass ring (1) comprises a fifth (10) and a sixth (11) side, which are arranged mutually opposite and in parallel, each having exactly four corners, and the glass ring (1) has a circular cylindrical through-opening, which extends in particular through the fifth (10) and the sixth (11) side,
wherein, adjacent to the third side (8) of the glass ring (1), a second side (7) is arranged comprising, adjacent to the sixth side (11), a first, trapezoidal planar partial surface, and comprising, adjacent to the fifth side (10), a trapezoidal partial surface that is composed of two triangular surfaces (7', 7") that are tilted with respect to one another, a second (7') and a third (7") partial surface of the second side (7),
wherein the third (7") partial surface of the second side (7) is tilted through an angle of 2 degrees, with respect to the second (7') partial surface of the second side (7),
wherein, adjacent to the second side (7), a fourth side (8), which is constructed from two mutually adjacent partial surfaces that are tilted with respect to one another, with each partial surface having a trapezoidal shape, is comprised,
wherein, adjacent to the third side (8), a first side (6), which is constructed of two mutually adjacent partial surfaces (6', 6") that are tilted with respect to one another, with each partial surface having a trapezoidal shape, is comprised.
wherein the first partial surface (8') of the third side (8) is arranged, to reflect a light beam coming from the fourth side (9) further to the second partial surface (7'') of the second side (7), wherein the reflection to and at the first partial surface (6') of the first side (6) leads to the sixth side (11), to an exit of the light beam from the glass ring (1) via the sixth side (11).

2. The glass ring (1) as claimed in claim 1,
**characterized in that**
the glass ring (1) is configured such that, in the case of a circulation of light around the conductor (2) without any flow of current, the polarization of the light is substantially completely maintained.

3. The glass ring (1) as claimed in one of the preceding claims,
**characterized in that**
the glass body comprises a glass having a Verdet constant that is greater or smaller than zero and/or consists of a glass having a Verdet constant that is greater or smaller than zero.

4. A method for optically measuring currents with a glass ring (1) as claimed in one of the preceding claims,
**characterized in that**
a flow of current (3) in an electrical conductor (2) generates an electromagnetic field around the conductor (2), via which the polarization of a light beam in the glass ring (1), which is arranged around the conductor (2), in particular with a plane perpendicular to the longitudinal axis of the conductor, is changed during a circulation of the light beam around the conductor (2).

5. The method as claimed in claim 4,
**characterized in that**,
during a circulation around the conductor (2), the light beam travels through a monolithic glass body, wherein changes in directions of the light beam are realized via reflection at external sides of the glass body, in particular at a third partial surface (7") of the second side (7) that is tilted, in particular through an angle of 2 degrees, with respect to a second (7') partial surface of the second side (7).

6. The method as claimed in either of claims 4 and 5, **characterized in that**
the light enters the glass body through the light entry surface (4) and exits the glass body at the light exit surface (5), and/or the light enters the glass body in particular via the third side (8) of the glass ring (1), in particular via two adjacent partial surfaces tilted by an angle with respect to one another and/or exits the glass body on the sixth side (11) of the glass ring (1), in particular at an angle of substantially 90 degrees relative to the entering light.

## Revendications

1. Anneau en verre (1) pour mesurer un courant, comprenant un corps en verre apte à être agencé autour d'un conducteur électrique (2) et comprenant une surface (4) d'entrée de lumière et une surface (5) de sortie de lumière, l'anneau en verre (1) étant conçu de façon à permettre à la lumière qui pénètre dans le corps en verre par la surface (4) d'entrée de lumière de circuler complètement autour du conducteur (2) par réflexion sur les faces extérieures du corps en verre, la lumière sortant du corps en verre par la surface (5) de sortie de lumière, l'anneau en verre (1) étant formé d'un corps en verre monolithique,
la surface (4) d'entrée de lumière étant un troisième côté (8) de l'anneau en verre (1), qui comprend deux surfaces partielles voisines, inclinées l'une par rapport à l'autre selon un angle, une surface partielle (8') présentant une forme triangulaire, l'anneau de verre (1) comprenant un cinquième (10) et un sixième (11) côté, opposés et parallèles l'un à l'autre, et présentant chacun exactement quatre coins, et l'anneau de verre (1) présentant une ouverture cylindrique circulaire continue, qui traverse le cinquième (10) et le sixième (11) côtés, un deuxième côté (7) étant agencé au voisinage du troisième côté (8) de l'anneau de verre (1), lequel comprend une première surface partielle plane trapézoïdale adjacente au sixième côté (11), et qui comprend, à proximité du cinquième côté (10), une surface partielle trapézoïdale, qui est composée de deux surfaces triangulaires (7', 7") inclinées l'une par rapport à l'autre, d'une deuxième (7') et d'une troisième (7") surface partielle du deuxième côté (7),
la troisième surface partielle (7'') du deuxième côté étant inclinée d'un angle de 2 degrés par rapport à la deuxième surface partielle (7') du deuxième côté (7),
un quatrième côté (9) étant adjacent au deuxième côté (7) et étant constitué de deux surfaces partielles adjacentes inclinées l'une par rapport à l'autre et agencées l'une à côté de l'autre, chaque surface partielle étant de forme trapézoïdale,
un premier côté (6) étant adjacent au troisième côté (8) et étant constitué de deux surfaces partielles (6', 6") agencées de manière adjacente l'une à l'autre et inclinées l'une par rapport à l'autre, chaque première surface partielle étant de forme trapézoïdale, la première surface partielle (8') du troisième côté (8) étant agencée de manière à réfléchir un faisceau de lumière provenant du quatrième côté (9) vers la deuxième surface partielle (7'') du deuxième côté (7), la réflexion vers et sur la première surface partielle (6") du premier côté (6) vers le sixième côté (11) conduisant à une sortie du faisceau de lumière de l'anneau de verre (1) par le sixième côté (11).

2. Anneau en verre selon la revendication 1, **caractérisé en ce que** l'anneau en verre est conçu de telle sorte que la polarisation de la lumière est sensiblement complètement conservée lors d'une circulation de la lumière autour du conducteur (2) sans circulation de courant.

3. Anneau en verre (1) selon l'une des revendications précédentes, **caractérisé en ce que** le corps en verre comprend un verre ayant une constante de Verdet supérieure ou inférieure à zéro et/ou est constitué d'un verre ayant une constante de Verdet supérieure ou inférieure à zéro.

4. Procédé de mesure optique de courant avec un anneau en verre (1) selon l'une des revendications précédentes, **caractérisé en ce qu'**un flux de courant (3) dans un conducteur électrique (2) génère un champ électromagnétique autour du conducteur (2), par l'intermédiaire duquel la polarisation d'un faisceau de lumière dans l'anneau en verre (1), qui est agencé autour du conducteur (2), est modifiée, en particulier avec un plan perpendiculaire à l'axe longitudinal du conducteur, lors d'une rotation du faisceau de lumière autour du conducteur (2).

5. Procédé selon la revendication 4,
**caractérisé en ce que**
le faisceau de lumière traverse un corps en verre monolithique lors d'une rotation autour du conducteur (2), les changements de direction du faisceau de lumière étant effectués par réflexion sur les côtés extérieurs du corps en verre, en particulier sur une troisième surface partielle (7'') du deuxième côté (7) inclinée par rapport à une deuxième surface partielle (7') du deuxième côté (7), en particulier d'un angle de 2 degrés.

6. Procédé selon l'une des revendications 4 ou 5,
**caractérisé en ce que**
la lumière entre dans le corps en verre par la surface (4) d'entrée de lumière, et sort du corps en verre par la surface (5) de sortie de lumière, et/ou **en ce que** la lumière entre dans le corps en verre en particulier par le troisième côté (8) de l'anneau en verre (1), en particulier par l'intermédiaire de deux surfaces partielles voisines, inclinées l'une par rapport à l'autre selon un angle, et/ou sort du corps en verre par le sixième côté (11) de l'anneau en verre (1), en particulier selon un angle de sensiblement 90 degrés par rapport à la lumière entrante.
